**Europäisches Patentamt**

**European Patent Office**

**Office européen des brevets**

(19)

(11) Veröffentlichungsnummer: **0 014 350**
**B1**

(12) **EUROPÄISCHE PATENTSCHRIFT**

(45) Veröffentlichungstag der Patentschrift:
18.05.83

(51) Int. Cl.³: **H 03 F 3/08**

(21) Anmeldenummer: **80100223.9**

(22) Anmeldetag: **17.01.80**

(54) **Monolithisch integrierte Halbleiterschaltung.**

(30) Priorität: **05.02.79 DE 2904316**

(43) Veröffentlichungstag der Anmeldung:
**20.08.80 Patentblatt 80/17**

(45) Bekanntmachung des Hinweises auf die Patenterteilung:
**18.05.83 Patentblatt 83/20**

(84) Benannte Vertragsstaaten:
**FR GB IT**

(56) Entgegenhaltungen:
**US-A-4092611**

(73) Patentinhaber: **SIEMENS AKTIENGESELLSCHAFT,
Berlin und München Wittelsbacherplatz 2,
D-8000 München 2 (DE)**

(72) Erfinder: **Fenk, Josef, Dipl.-Ing.,
Deutenhauserstrasse 10, D-8057 Eching/ottenburg (DE)**

ACTORUM AG

## Monolithisch integrierte Halbleiterschaltung

Die Erfindung betrifft eine monolithisch integrierte Halbleiterschaltung, bei der eine in Sperrichtung gepolte Photodiode zur Steuerung des einen Signaleingangs und ein Referenzpotential zur Beaufschlagung des anderen Signaleingangs eines Differenzverstärkers vorgesehen und ausserdem der nichtinvertierende Signalausgang des Differenzverstärkers über einen weiteren Verstärker an den durch die Photodiode beaufschlagten invertierenden Signaleingang des Differenzverstärkers rückgekoppelt ist.

Eine solche Schaltung ist in der US-PS 4 092 611 beschrieben und dient zur automatischen Steuerung der Einstellung optischer Aufnahmegeräte.

Das am Signalausgang einer solchen Schaltung abgegebene Signal setzt sich ausser der durch die optische Beaufschlagung der Photodiode gegebenen Komponente aus durch Rauscheffekte in den beteiligten Schaltungsteilen bedingten Störkomponenten zusammen. Falls die Schaltung für eine Signalübertragung eingesetzt werden soll, wäre eine Unterdrückung dieser Störkomponenten durchaus erwünscht. Ferner sollte dann auch der durch eine dauernde optische Beaufschlagung, z.B. durch Hintergrundlicht, bedingte Anteil des Ausgangssignals zugunsten eines durch einen raschen Belichtungswechsel der Photodiode bedingten Signalanteils möglichst unterdrückt werden. Es ist deshalb Aufgabe der Erfindung, eine Schaltungsanordnung anzugeben, welche

1. aufgrund eines niedrigen Gleichstromwiderstandes bei auftretender maximaler Gleichlicht-Bestrahlungsintensität zu keiner Begrenzung des Photostroms führt, und die

2. eine Spannungsmittelkopplung enthält, welche durch Kompensation der parasitären Diodenkapazität die nutzbare Grenzfrequenz, beziehungsweise den zulässigen Lastwiderstand erhöht. Ferner ist

3. eine Reduzierung der gleichlichtbedingten Begrenzung des Wechsellicht-Photostroms bei gleichzeitig grossen nutzbaren Wechsellicht-Impedanzen für den Wechsellichtstrom und eine Verminderung des Einflusses der parasitären Diodenkapazität angestrebt.

Erfindungsgemäss wird hierzu eine der eingangs gegebenen Definition entsprechende Halbleiterschaltung derart ausgestaltet, dass der invertierende Signaleingang mit dem nichtinvertierenden Signaleingang des Differenzverstärkers über einen Kopplungswiderstand verbunden ist, dass ausserdem die Rückkopplung vom nichtinvertierenden Signalausgang des Differenzverstärkers zu dessen invertierenden Signaleingang in Reihe mit dem weiteren Verstärker eine Filterschaltung enthält, dass weiter sowohl der invertierende Ausgang des Differenzverstärkers als auch der zweite Anschluss der Photodiode mit dem gemeinsamen Bezugspotential (Masse) über je einen Widerstand verbunden sind, und dass schliesslich die Filterschaltung derart gewählt ist, ausserhalb der Nutzsignalfrequenzen eine minimale Dämpfung vorliegt, während innerhalb des Bereichs der Nutzsignalfrequenzen, die durch sie verursachte Dämpfung für die gewählte Übertragungsfrequenz grosser als die im Rückkopplungszweig aufgrund der beiden Verstärker bedingte Gesamtverstärkung bemessen ist.

Mit einer solchen Verstärkerschaltung ist erreicht, dass ausreichend grosse Lastwiderstände zulässig sind, ohne dass es dabei zu einer Begrenzung des Photostroms kommt, und dass wenigstens ein Teil der störenden Kapazität der Photodiode kompensiert wird. Bei der soeben definierten Schaltung wird also der nichtinvertierende Eingang einer Differenzstufe an eine Referenzspannung $U_r$ gelegt. Der invertierende Eingang liegt an einem Summationspunkt. An diesem Summationspunkt sind die in Sperrichtung betriebene Photodiode, ein Lastwiderstand und der hochohmige Kollektorausgang eines der den Differenzverstärker bildenden Transistoren angeschlossen. Dieser Transistor bildet einen Teil einer Regelschleife, die aus der Differenzstufe, der Filterschaltung und dem genannten Transistor besteht. Diese Regelschaltung wirkt in der Art eines als Spannungsfolger geschalteten Operationsverstärkers. Es stellt sich damit am Summationspunkt eine Spannung entsprechend der Referenzspannung $U_r$ ein. Damit erhält man für alle Frequenzen im Durchlassbereich der Filterschaltung eine sehr niedrige Impedanz. Für alle Frequenzen ausserhalb des Durchlassbereichs der Filterschaltung steigt die Impedanz am Summationspunkt umgekehrt proportional zur Abnahme der Schleifenverstärkung an. Liegt die Übertragungsfrequenz weit ausserhalb des Durchlassbereichs der Filterschaltung, so lassen sich sehr hohe Lastwiderstände einstellen und damit auch grosse Nutzsignalspannungen. Damit erhält man ein möglichst grosses Verhältnis von Signalspannung zu Rauschspannung am zweiten Ausgang der Differenzstufe, also dem nichtinvertierenden Ausgang der Differenzstufe, der zugleich den Signalausgang der Schaltung bildet. Ein externer Widerstand oder ein Resonanzkreis kann als Lastwiderstand für das Nutzsignal eingesetzt werden. Die Kompensation der Diodenkapazität wird dadurch erzielt, dass in Reihe zur Anode der Photodiode ein relativ kleiner Widerstand liegt, an dem sich durch Spannungsmitkopplung die gleiche Spannung wie an der Kathode der Photodiode einstellt. Die parasitäre Diodenkapazität muss damit nicht umgeladen werden, so dass ihr Einfluss wesentlich reduziert ist.

Die Erfindung wird nun anhand der Fig. 1 bis 3 näher beschrieben. Dabei ist in Fig. 1 das einen zusätzlichen Schaltungsteil aufweisende Prinzipschaltbild einer Vorrichtung gemäss der Erfindung und in Fig. 2 eine Ergänzungsschaltung zur weiteren Verminderung der parasitären Diodenkapazität und in Fig. 3 das Layout einer integrierten Photodiode dargestellt.

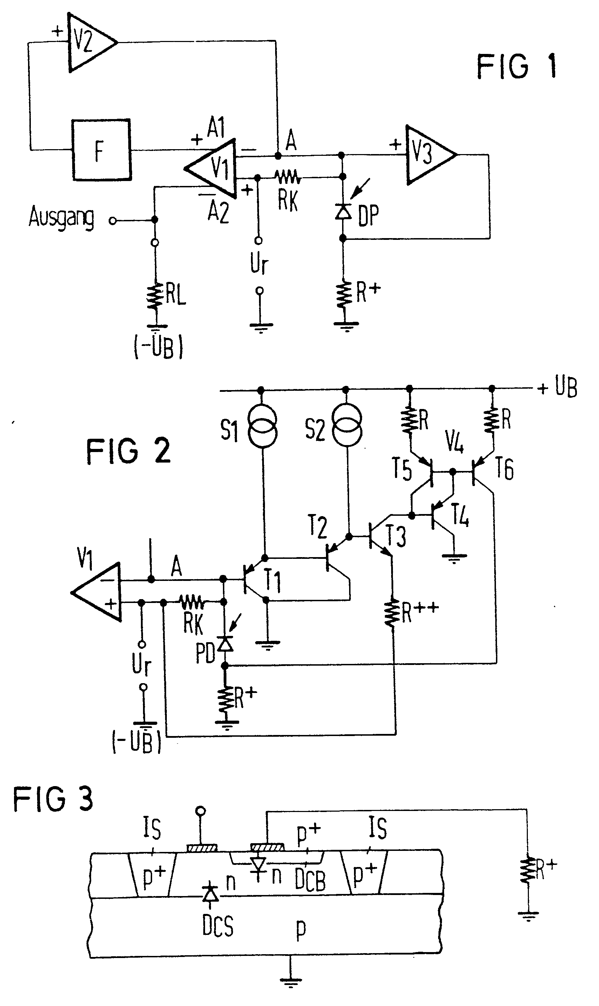

Zunächst wird auf Fig. 1 eingegangen. Die dort dargestellte Schaltung weist einen die Differenzstufe bildenden Differenzverstärker $V_1$ auf, dessen nichtinvertierender Eingang «+» an eine Referenzspannung $U_r$ gelegt ist. Da der nicht invertierende Ausgang $A_1$ des Differenzverstärkers $V_1$ über eine Filterschaltung F und einen Transistorverstärker $V_2$ an den invertierenden Eingang des Differenzverstärkers $V_1$ rückgekoppelt ist und da ausserdem die Kathode der Photodiode PD ebenfalls auf den betreffenden Eingang des Differenzverstärkers $V_1$ geschaltet ist, ergibt sich auf diese Weise ein als Summationspunkt A dienender Schaltungsknoten.

Ferner ist der nichtinvertierende Eingang – des Differenzverstärkers $V_1$ gegenüber der an dem Bezugspotential liegenden Masse auf ein Referenzpotential gelegt, so dass zwischen Masse und dem genannten Eingang – des Differenzverstärkers $V_1$ eine Referenzspannung $U_r$ gegeben ist. Aufgrund dieser Beaufschlagung und der über die Filterschaltung F und dem dieser nachgeschalteten Transistorverstärker $V_2$ ist nun ein Regelverhalten der Schaltung gegeben, die lediglich noch durch einen zwischen der Anode der Photodiode PD und Masse, also dem Bezugspotential, liegenden Lastwiderstand $R^+$ zu ergänzen ist. Ausdrücklich zu bemerken ist hierbei, dass die durch das am nichtinvertierenden Eingang «+» des Differenzverstärkers $V_1$ bestimmte Potential an der Anode der Photodiode PD derart im Vergleich zu dem an Masse liegenden Bezugspotential zu wählen ist, dass die Diode durch die hierdurch bedingte Vorspannung permanent in Sperrichtung liegt.

Um eine möglichst günstige Wirkung hinsichtlich der Vermeidung einer Begrenzung des Photostroms bei maximal auftretenden Gleichlicht-Bestrahlungsstärken zu erzielen, empfiehlt es sich auf jeden Fall, wenn die Filterschaltung F derart gewählt ist, dass ausserhalb der Nutzsignalfrequenzen eine minimale Dämpfung vorliegt und innerhalb der Nutzsignalfrequenzen, die durch sie verursachte Dämpfung für die gewählte Übertragungsfrequenz f grösser als die durch die beiden Verstärker im Rückkopplungszweig, also dem Differenzverstärker $V_1$ und dem (durch einen einfachen Transistor im einfachsten Fall gegebenen) zweiten Verstärker $V_2$ bewirkte Gesamtverstärkung bemessen ist.

Zur Unterstützung dieser Prinzipschaltung, vor allem im Interesse einer weitgehenden Verminderung der parasitären Kapazität der Photodiode PD, empfiehlt es sich ferner, wenn die Anode der Photodiode DP mit dem Ausgang und die Kathode mit dem hochohmigen Eingang eines weiteren Verstärkers, beziehungsweise Verstärkerschaltung $V_3$ verbunden wird, wie dies in Fig. 1 dargestellt ist. Diese Massnahme ist vor allem dann wichtig, wenn die integrierte Schaltung einschliesslich der Photodiode PD in einer epitaktischen Schicht erzeugt ist, die auf einem Halbleitersubstrat des entgegengesetzten Leitungstyps abgeschieden ist.

Für diesen Fall empfiehlt sich besonders die aus Fig. 2 ersichtliche Verstärkerschaltung. Bei dieser ist die Kathode der in Sperrichtung betriebenen Photodiode PD an die Basis eines ersten Bipolartransistors $T_1$ vom einen Typ geschaltet, dessen Kollektor am gemeinsamen Bezugspotential, also an Masse, gelegt ist, während sein Emitter durch einen ersten Stromversorger $S_1$, also Stromversorger-Transistor, gesteuert ist. Ausserdem liegt der Emitter des Transistors $T_1$ an der Basis eines dem Transistor $T_1$ gleichen zweiten Bipolartransistor $T_2$.

Der Kollektor dieses zweiten Bipolartransistors $T_2$ ist ebenfalls an Masse gelegt, während sein Emitter wiederum mit einem Stromversorgungstransistor $S_2$ und ausserdem mit der Basis eines dritten Bipolartransistors $T_3$ verbunden ist.

Der dritte Bipolartransistor $T_3$ ist gegenüber den Transistoren $T_1$ und $T_2$ vom entgegengesetzten Typ und ist auch bezüglich seines Emitters und seines Kollektors anders als die beiden Transistoren $T_1$ und $T_2$ geschaltet. Der Emitter des Transistors $T_3$ liegt nämlich über einen Vorwiderstand $R_3$ am nichtinvertierenden Eingang «+» des Differenzverstärkers $V_1$ oder – was dasselbe ist – am Referenzpotential $U_r$. Der Kollektor dieses Transistors $T_3$ steuert einen Stromspiegelverstärker $V_4$ bekannter Art.

Dieser Stromspiegelverstärker $V_4$ besteht aus drei Bipolartransistoren vom Typ der beiden ersten Transistoren $T_1$ und $T_2$ der in Fig. 3 dargestellten Verstärkerschaltung. Zwei dieser Transistoren, nämlich die Transistoren $T_5$ und $T_6$, sind über ihre Basisanschlüsse miteinander verbunden und liegen mit ihren Emittern über gleiche Vorwiderstände R am Betriebspotential $+U_B$. Ausserdem sind diese beiden Transistoren $T_5$ und $T_6$ durch den Kollektor des dritten Transistors $T_4$ unterstützend gesteuert, dessen Basis mit dem Kollektor des Transistors $T_3$ verbunden ist und dessen Kollektor an Masse liegt.

Die Stromversorgungstransistoren $S_1$ und $S_2$ entsprechen bezüglich ihrer Schaltung den Transistoren $T_5$ und $T_6$ des Stromspiegels bezüglich der Emitter und Kollektoranschlüsse und sind vom selben Typ. Ihre Basisanschlüsse werden durch eine gemeinsame Vorspannung beaufschlagt.

Aufgrund der beschriebenen und in Fig. 1 dargestellten Schaltung bilden die an der Rückkopplungsschleife beteiligten Schaltungsteile, nämlich der Differenzverstärker $V_1$, die Filterschaltung F und der Transistorverstärker $V_2$ eine Regelschleife in der Art eines als Spannungsfolger geschalteten Operationsverstärkers. Es stellt sich damit am Summationspunkt A ein Potential entsprechend dem Referenzpotential $V_r$ ein. Am Summationspunkt A erhält man somit für alle Frequenzen im Durchlassbereich des Filters F eine sehr niedrige Impedanz. Für alle Frequenzen ausserhalb des Durchlassbereichs steigt die Impedanz umgekehrt proportional der Abnahme der Schleifenverstärkung an. Liegt die Signalfrequenz weit ausserhalb des Durchlassbereichs der Filterschaltung F, so lassen sich sehr hohe Lastwiderstände $R_K$ einstellen.

Die Filterschaltung kann zum Beispiel als Tiefpassfilter, insbesondere als zweigliedriges Tiefpassfilter F, ausgestaltet sein. Eine andere vorteilhafte Möglichkeit wäre mit der Ausgestaltung der Filterschaltung F als Bandsperre mit einer der Übertragungsfrequenz entsprechenden Sperrfrequenz. Beträgt zum Beispiel die Übertragungsfrequenz 30 kHz, so wird man zum Beispiel die Filterschaltung F als Tiefpass mit einer Eckfrequenz von <3,0 kHz oder als Bandsperre mit einer Sperrfrequenz von 30 kHz ausbilden. Einsetzbar sind sowohl aktive als auch passive Filterschaltungen.

Bei einer Realisierung der Schaltung in monolithisch integrierter Halbleitertechnik wird man mit Vorteil die Filterschaltung F als Tiefpass in Form eines Filters mit integrierten Kapazitäten anwenden. Der Nutzsignalstrom kann am Ausgang $A_2$ des Differenzverstärkers $V_1$ entnommen werden, wie dies aus Fig. 1 ersichtlich ist. Die erzielte Verstärkung lässt sich aus dem Produkt der resultierenden Steilheit des Differenzverstärkers $V_1$ und dem externen Lastwiderstand errechnen.

Wird der Verstärker $V_3$ mit einer Spannungsübersetzung von 1 versehen, so wird, da der Kopplungswiderstand $R_K$ als Lastwiderstand wirkt, die parasitäre Diodenkapazität nicht umgeladen und damit ihr Einfluss wesentlich reduziert.

Um keine Begrenzung des Photodiodenstroms bei hohen Gleichlicht-Bestrahlungsstärken der Photodiode PD zu erhalten, wird der die Photodiode PD an das Bezugspotential, also an Masse, legende Widerstand $R^+$ wesentlich kleiner als der Widerstand $R_K$ gewählt, der den invertierenden Eingang von $V_1$, das heisst also den Eingang der Schaltung $V_1$, mit dem Bezugspotential $(U_r)$ verbindet.

Zumeist wird in der integrierten Schaltung die Photodiode PD in der aus der Fig. 3 ersichtlichen Weise realisiert:

Auf einem scheibenförmigen einkristallinen Substrat aus Silicium wird eine n-dotierte epitaktische Schicht aus demselben Halbleitermaterial erzeugt, in welcher dann die einzelnen Bestandteile der monolithisch integrierten Halbleiterschaltung – gegebenenfalls durch hochdotierte und den Leitungstyp des Substrats aufweisende Isolierzonen IS getrennt – erzeugt werden. Für die Photodiode PD hat dies zur Folge, dass für diese zwei parasitäre Kapazitäten, nämlich die Kapazität des in Sperrrichtung liegenden pn-Übergangs dieser Diode, also die Kapazität der Diode $D_{CB}$, als auch die Kapazität der Substratdiode $D_{CS}$ zu berücksichtigen ist.

Die in Fig. 2 dargestellte Ausgestaltung des zur Verminderung der parasitären Diodenkapazitäten dienenden Verstärkers $V_3$ ist zur Lösung dieser Aufgabe in Verbindung mit den übrigen Massnahmen der Erfindung bestens geeignet. Bedingt ist dies dadurch, dass in Serie zur durch den pn-Übergang der Photodiode PD gegebenen Diode $D_{CB}$ der Kopplungswiderstand $R^+$ gegen Masse geschaltet ist, so dass das Signal über den Transistor $T_1$ und $T_2$ an die Basis des Transistors $T_3$ gelangt. Zwischen dem Emitter des Transistors $T_3$ und dem Referenzpotential $U_r$ liegt der Widerstand $R^{--}$. Bei einer Spannungsverstärkung im Wert 1 erhält man näherungsweise für den Widerstand $R^-$ den Wert

$$R^- = R^- - \gamma_{eT_3} \text{ mit } \gamma_{eT_3} = U_T : I_{eT_3}$$

wobei $R^-$ den Widerstand zwischen Anode PD und Masse, $\gamma_{eT_3}$ den dynamischen Emitterwiderstand von $T_3$,
$U_T$ die Diffusionsspannung und
$I_{eT_3}$ den Emitterstrom von $T_3$ bedeutet.

Die maximal zulässige Spannungsverstärkung des Verstärkers $V_3$ beträgt

$$V_{max} = 1 + (C_E : C_{CB}),$$

wobei $C_{CB}$ die Kapazität der Diode $D_{CB}$ und $C_E$ die Summe der Kapazitäten am Summationspunkt, bestehend aus den Eingangskapazitäten der an A liegenden Verstärker $V_1$ und der Kapazität der Substratdiode $D_{CS}$ ist. Die resultierende Spannung $U_{CB}$ über der eigentlichen Photodiode $D_{CB}$ ist durch

$$U_{CB} = U_r - 0,7 \text{ V}$$

gegeben.

Für den Fall, dass die aus Fig. 2 ersichtlichen Polaritäten beziehungsweise Dotierungsverhältnisse beim Aufbau der Photodiode PD angewendet sind, empfiehlt es sich, wenn die Transistoren $T_1$, $T_2$, $T_4$ bis $T_6$ vom pnp-Typ und der Transistor $T_3$ vom npn-Typ ist. Ist hingegen das Substrat n-leitend, so kehren sich alle Dotierungsverhältnisse um.

## Patentansprüche

1. Monolithisch integrierte Halbleiterschaltung, bei der eine in Sperrichtung gepolte Photodiode (DP) zur Steuerung des einen Signaleingangs (−) und ein Referenzpotential (Wr) zur Beaufschlagung des anderen Signaleingangs (+) eines Differenzverstärkers $(V_1)$ vorgesehen und ausserdem der nichtinvertierende Signalausgang (+) des Differenzverstärkers $(V_1)$ über einen weiteren Verstärker $(V_2)$ an den durch die Photodiode (DP) beaufschlagten invertierenden Signaleingang (−) des Differenzverstärkers $(V_1)$ rückgekoppelt ist, dadurch gekennzeichnet, dass der invertierende Signaleingang mit dem nichtinvertierenden Signaleingang des Differenzverstärkers $(V_1)$ über einen Kopplungswiderstand $(R_K)$ verbunden ist, dass ausserdem die Rückkopplung vom nichtinvertierenden Signalausgang des Differenzverstärkers $(V_1)$ zu dessen invertierenden Signaleingang in Reihe mit dem weiteren Verstärker $(V_2)$ eine Filterschaltung (F) enthält, dass weiter sowohl der invertierende Ausgang des Differenzverstärkers $(V_1)$ als auch der zweite Anschluss der Photodiode (PD) mit dem gemeinsamen Bezugspotential (Masse) über je einen Widerstand $(R_L, R+)$ verbunden sind, und dass schliesslich die Filterschaltung (F) derart gewählt ist, dass ausserhalb der Nutzsignalfrequenzen eine minimale Dämpfung vorliegt, während innerhalb des Bereichs der Nutzsignalfrequenzen die durch sie verursachte Dämpfung für die gewählte Übertragungsfrequenz (f) grösser als die im Rückkopplungszweig aufgrund der beiden Verstärker (V$_1$, V$_2$) bedingte Gesamtverstärkung bemessen ist.

2. Vorrichtung nach Anspruch 1, dadurch gekennzeichnet, dass die zwischen dem nicht invertierenden Ausgang (A1) des Differenzverstärkers (V1) und dem weiteren Verstärker (V$_2$) vorgesehene Filterschaltung (F) als Tiefpassfilter, insbesondere als zweigliedriges Tiefpassfilter, ausgestaltet ist.

3. Vorrichtung nach Anspruch 1, dadurch gekennzeichnet, dass die Filterschaltung (F) als Bandsperre mit einer der Übertragungsfrequenz entsprechenden Sperrfrequenz ausgebildet ist.

4. Vorrichtung nach einem der Ansprüche 1 bis 3, dadurch gekennzeichnet, dass der die Photodiode (PD) mit dem Bezugspotential (Masse) verbindende Widerstand (R$^+$) kleiner als der gemeinsam am nichtinvertierenden Eingang und am invertierenden Eingang des Differenzverstärkers (V$_1$) sowie am Referenzpotential (U$_r$) liegende Widerstand (R$_K$) bemessen ist.

5. Vorrichtung nach einem der Ansprüche 1 bis 4, dadurch gekennzeichnet, dass der zur Beaufschlagung des Differenzverstärkers (V$_1$) dienende Anschluss der Photodiode (PD) an den Eingang eines dritten Verstärkers (V$_3$) gelegt ist, der mit seinem Ausgang an den anderen Anschluss der Photodiode als auch an den diesen Anschluss der Photodiode (PD) mit dem Bezugspotential (Masse) verbindenden Widerstand (R$^-$) angelegt ist.

## Claims

1. A monolithic integrated semiconductor circuit, wherein a photodiode poled in the blocking direction is provided to control one signal input and a reference potential is provided to control the other signal input of a difference amplifier, and wherein furthermore the non-inverting signal output of the difference amplifier is fed back via a further amplifier to the inverting signal input of the difference amplifier, which is controlled by the photodiode, characterised in that the inverting signal input is connected to the non-inverting signal input of the difference amplifier (V$_1$) by a coupling resistance (R$_K$), the feedback from the non-inverting signal output of the difference amplifier (V$_1$) to the inverting signal input thereof comprises a filter circuit (F) in series with the further amplifier (V$_2$), both the inverting output of the difference amplifier (V$_1$) and the second terminal of the photodiode (PD) are connected to the common reference potential (earth) by a respective resistance (R$_L$, R$^+$) and that the filter circuit (F) is finally selected in such a manner that a minimal attenuation exists outside the useful signal frequencies, whereas within the range of the useful signal frequencies, the attenuation caused by the latter, for the selected transmission frequency (f) is greater than the overall amplification which is conditioned by the two amplifiers (V$_1$, V$_2$) in the feedback branch.

2. A device as claimed in claim 1, characterised in that the filter circuit (F) arranged between the non-inverting output (A1) of the difference amplifier (V1) and the further amplifier (V$_2$) is a low-pass filter, in particular a two-membered low-pass filter.

3. A device as claimed in claim 1, characterised in that the filter circuit (F) is a band stop filter having a blocking frequency which corresponds to the transmission frequency.

4. A device as claimed in one of claims 1 to 3, characterised in that the resistance (R$^+$) which connects the photodiode (PD) to the reference potential (earth) is smaller than the resistance (R$_K$) which commonly links the non-inverting input and the inverting input of the difference amplifier (V$_1$) and the reference potential (U$_r$).

5. A device as claimed in one of claims 1 to 4, characterised in that the terminal of the photodiode (PD) which serves to control the difference amplifier (V$_1$) is applied to the input of a third amplifier (V$_3$) whose output is connected both to the other terminal of the photodiode and to the resistance (R$^-$) which connects this terminal of the photodiode (PD) to the reference (earth).

## Revendications

1. Circuit à semiconducteurs intégré monolithiquement, dans lequel une diode photosensible polarisée dans le sens de non conduction est prévue pour commander l'une des entrées de signaux et un potentiel de référence est prévu pour alimenter l'autre entrée de signaux d'un amplificateur différentiel, et en outre la sortie de signaux non inverseuse de l'amplificateur différentiel est ramenée, par l'intermédiaire d'un autre amplificateur, à l'entrée de signaux inverseuse, alimentée par la diode photosensible, de l'amplificateur différentiel, caractérisé par le fait que l'entrée de signaux inverseuse est reliée directement à l'entrée de signaux non inverseuse de l'amplificateur différentiel (V$_1$) par une résistance de couplage (R$_K$), qu'en outre la réaction entre la sortie de signaux non inverseuse de l'amplificateur différentiel (V$_1$) et son entrée de signaux inverseuse comprend un circuit de filtre (F) en série avec l'autre amplificateur (V$_2$), que de plus aussi bien la sortie inverseuse de l'amplificateur différentiel (V$_1$) qu'également la seconde borne de la diode photosensible (PD) sont reliées au potentiel de référence commun (masse) respectivement par l'intermédiaire d'une résistance (R$_L$, R$^+$) et qu'enfin le circuit de filtre (F) est choisi de manière que l'affaiblissement soit minimal à l'extérieur des fréquences de signaux utiles tandis que dans la gamme des fréquences de signaux utiles l'affaiblissement qu'il provoque pour la fréquence de transmission choisie (f) est plus important que l'amplification globale apparaissant dans la branche de réaction par suite des deux amplificateurs (V$_1$, V$_2$).

2. Dispositif suivant la revendication 1, caractérisé par le fait que le circuit de filtre (F) prévu entre la sortie non inverseuse (A1) de l'amplificateur

différentiel ($V_1$) et l'autre amplificateur ($V_2$) se présente sous la forme d'un filtre passe-bas, notamment sous la forme d'un filtre passe-bas à deux éléments.

3. Dispositif suivant la revendication 1, caractérisé par le fait que le circuit de filtre (F) se présente sous la forme d'un filtre coupe-bande possédant une fréquence d'arrêt correspondant à la fréquence de transmission.

4. Dispositif suivant l'une des revendications 1 à 3, caractérisé par le fait que la résistance ($R^+$) reliant la diode photosensible (PD) au potentiel de référence (masse) est plus faible que la résistance ($R_K$) reliée en commun à l'entrée non inverseuse et à l'entrée inverseuse de l'amplificateur différentiel ($V_1$) ainsi qu'au potentiel de référence ($U_r$).

5. Dispositif suivant l'une des revendications 1 à 4, caractérisé par le fait que la borne de la diode photosensible (PD) servant à alimenter l'amplificateur différentiel ($V_1$) est reliée à l'entrée d'un troisième amplificateur ($V_3$) dont la sortie est reliée à l'autre borne de la diode photosensible ainsi qu'à la résistance ($R^+$) reliant cette borne de la diode photosensible (PD) au potentiel de référence (masse).

FIG 1

FIG 2

FIG 3